# EUROPÄISCHE PATENTSCHRIFT

(11) **EP 1 196 996 B1**
(45) Veröffentlichungstag und Bekanntmachung des Hinweises auf die Patenterteilung: **26.01.2005**
(21) Anmeldenummer: 00958144.8
(22) Anmeldetag: 18.07.2000
(51) Int. Cl.: H03L 7/08

(54) **Elektronische Schaltung mit einem digitalen und analogen Schaltungsabschnitt, für eine Phasenregelschleife**
Electronic circuit with a digital section and an analog section, for a PLL
Circuit éléctronique avec une partie numérique et une partie analogique, pour une boucle à verouillage de phase

(30) Priorität: 19.07.1999 DE 19933799
(43) Veröffentlichungstag der Anmeldung: 17.04.2002
(73) Patentinhaber: Infineon Technologies AG, 81669 München (DE)
(72) Erfinder: GÖTZ, Edmund, D-85221 Dachau (DE); SCHOLZ, Markus, D-81737 München (DE); FENG, Shen, San Diego, CA 92121 (US)
(74) Vertreter: Epping Hermann & Fischer
(86) Internationale Anmeldenummer: PCT/DE2000/002323
(87) Internationale Veröffentlichungsnummer: WO 2001/006658

(56) Entgegenhaltungen:
- EP-A- 0 905 598
- US-A- 4 598 217
- US-A- 5 623 523
- PATENT ABSTRACTS OF JAPAN vol. 1996, no. 10, 31. Oktober 1996 (1996-10-31) & JP 08 162951 A (KYOCERA CORP), 21. Juni 1996 (1996-06-21)
- PATENT ABSTRACTS OF JAPAN vol. 017, no. 629 (E-1462), 19. November 1993 (1993-11-19) & JP 05 199101 A (NEC IC MICROCOMPUT SYST LTD), 6. August 1993 (1993-08-06)

## Beschreibung

Die Erfindung betrifft eine elektronische Schaltung, insbesondere für und in einem Mobilfunkgerät, die einen digitalen Schaltungsabschnitt und einen mit diesem verbundenen analogen Schaltungsabschnitt aufweist.

Es ist bekannt, bei Hochfrequenz-Sende- und Empfangskreisen Phasenregelkreise (PLL-Schaltungen) einzusetzen, die die Phase, und gegebenenfalls auch die Frequenz, des Senders und/oder Empfängers auf einen gewünschten Wert regeln. Hierzu wird häufig ein die Sende- oder Empfangsträgerfrequenz erzeugender spannungsgesteuerter Oszillator (VCO) durch die an ihn angelegte Spannung auf die Sollfrequenz geregelt. Zur Erzielung eines ausreichend großen Steuerungshubs ist ein entsprechend hoher Steuerspannungshub wünschenswert, der eine entsprechend hohe Versorgungsspannung benötigt. Andererseits erfolgt die übrige Signalverarbeitung beispielsweise in einem Mobilfunkgerät zum größten Teil auf digitaler Ebene. Dort werden zur Verringerung der Verlustleistung, Temperaturerzeugung und dergleichen zunehmend niedrige Versorgungsspannungen von beispielsweise 2,7 V eingesetzt. Solche niedrigen Versorgungsspannungen führen aber im Hochfrequenzteil zu einer nur geringen Aussteuerbarkeit, so daß der Tuningbereich eingeschränkt ist.

In der US-A-4 598 217 ist ein Phasen-/Frequenzdetektor für einen Phasenregelkreis gezeigt. Ein eingangsseitiger digitaler Schaltungsabschnitt ist an einen ausgangsseitigen analogen Schaltungsabschnitt gekoppelt. Der digitale Schaltungsabschnitt weist eine Versorgungsspannung von 5 V auf. Der analoge Schaltungsabschnitt weist eine andere Versorgungsspannung auf. Zur Umsetzung der vom digitalen auf den analogen Schaltungsabschnitt zu übertragenden Signalen ist ein Pegelwandler vorgesehen. Der Pegelwandler enthält Stromquellenund Stromspiegelschaltungen.

In Patent Abstracts of Japan, Band 1996, Nr. 10, 31. Oktober 1996 (JP-A-08-162951) ist ein Phasenregelkreis gezeigt, bei dem eine Ladungspumpe Ausgangssignale des Phasenkomparators auf das Schleifenfilter umsetzt. In der US-A-5 623 523 ist ein weiterer Phasenregelkreis gezeigt, bei dem digital bereitgestellte Aufwärts- und Abwärtspumpsignale eine Ladungspumpe ansteuern, die von einem Spannungs-Boost-Netzwerk angesteuert wird, das von einer anderen Versorgungsspannung versorgt wird. Die Ladungspumpe steuert ein Schleifenfilter.

Der Erfindung liegt die Aufgabe zugrunde, eine elektronische Schaltung, insbesondere für ein Mobilfunkgerät, zu schaffen, die sich durch gute Betreibbarkeit des digitalen und analogen Schaltungsabschnitts auszeichnet.

Diese Aufgabe wird mit den im Patentanspruch 1 genannten Merkmalen gelöst. Vorteilhafte Ausgestaltungen der Erfindung sind in den Unteransprüchen angegeben.

Bei der Erfindung sind für den digitalen Schaltungsabschnitt und den analogen Schaltungsabschnitt unterschiedliche Versorgungsspannungen vorgesehen, so daß getrennt günstige Versorgungsspannungspegel vorgegeben werden können, zum Beispiel 2,7 bis 3 V für den digitalen Schaltungsabschnitt und 5 V für den analogen Schaltungsabschnitt. Da die vom digitalen Schaltungsabschnitt zum analogen Schaltungsabschnitt gespeisten Steuersignale nur im Umfang ihrer Versorgungsspannung amplitudenvariiert werden können, sind vorzugsweise am Eingang oder Ausgang des digitalen und/oder analogen Schaltungsabschnitts Pegelumsetzer vorgesehen, die den Steuersignalspannungshub auf den von dem anderen Schaltungsabschnitt benötigten Aussteuerungshub transformieren.

In vorteilhafter Ausgestaltung umfaßt der analoge Schaltungsabschnitt eine gesteuerte Stromquellenschaltung mit vorgeschaltetem Referenzstromgenerator, der durch ein vom digitalen Schaltungsabschnitt zugeführtes Aktivierungssignal einund ausschaltbar ist. Dieses Aktivierungssignal wird durch einen Pegelumsetzer auf den höheren Pegelbereich der Spannungsversorgung des analogen Schaltungsabschnitts transformiert. An den Ausgang der Stromquellenschaltung ist vorzugsweise eine Steuerspannungserzeugungseinheit zur Erzeugung der Steuerspannung für die Frequenzsteuerung eines frequenzund/oder phasenstarr zu regelnden spannungsgesteuerten Oszillators angeschlossen. Damit kann die Aussteuerung des spannungsgesteuerten Oszillators mit dem höheren Pegelhub der Spannungsversorgung des analogen Schaltungsabschnitts betrieben und folglich hoher Aussteuerungsbereich erhalten werden. Die Steuerspannungserzeugungseinrichtung ist vorzugsweise ein Schleifenfilter mit entsprechend dem gewünschten Steuerspannungswert zu ladender und entladender Kapazität. Der das Oszillator-Ausgangssignal mit einem vorgegebenen Referenzsignal vergleichende Phasenvergleicher oder Phasen/Frequenz-Detektor ist dann vorzugsweise Bestandteil des digitalen Schaltungsabschnitts.

Vor die Steuerspannungseingänge der steuerbaren Stromquellenschaltung sind Pegelumsetzer geschaltet, so daß die von dem digitalen Schaltungsabschnitt zugeführten Steuersignale auf den höheren Spannungspegelhub der Stromquellenschaltung transformiert werden.

Es sind mehrere selektiv wählbare steuerbare Stromquellenschaltungen im analogen Schaltungsabschnitt vorhanden, die auf einen gemeinsamen Stromausgangsanschluß geschaltet sind. Hierbei ist eine Selektion der Stromquellenschaltungen durch ein oder mehrere Selektionssignale möglich, so daß die jeweils aktuell zum Stromausgangsanschluß gespeiste Stromstärke selektierbar ist.

Der Referenzstromgenerator enthält mehrere Referenzstromzweige, über die Referenzströme zu den einzelnen Stromquellenschaltungen gespeist werden können. Damit ist der vor dem Referenzstromgenerator angeordnete Pegelumsetzer mehrfach ausgenutzt, da ein einziger Pegelumsetzer zur Steuerung der Aktivierung mehrerer Referenzstromzweige dient. Dies verringert den notwendigen Schaltungsaufwand trotz der gebotenen Möglichkeit, mehrere Stromquellenschaltungen gleichzeitig speisen zu können.

Alle Referenzstromzweige können durch einen oder zwei elektronische, mit dem Pegelumsetzer verbundene Schalter ein- und ausgeschaltet werden, so daß der hierfür insgesamt benötigte Schaltungsaufwand gering ist.

Die Pegelumsetzer enthalten vorzugsweise einen Eingangszweig, der an der niedrigeren Versorgungsspannung liegt und dessen Ausgangspotential durch das eingangsseitig vom digitalen Schaltungsabschnitt zugeführte Steuer-Schaltsignal umgeschaltet wird. Dieser Eingangszweig ist mit einem an hoher Versorgungsspannung liegenden Umsetzzweig verbunden, so daß der Schaltsignalpegel nun zwischen dem für die beiden Zweige gemeinsamen Massepotential und hohem Spannungspotential umgeschaltet wird.

Die erfindungsgemäße Schaltung findet insbesondere in hybriden(analog und digital aufgebauten) Phasen- und/oder Frequenz-Reglern für Hochfreqenz-Oszillatoren, vorzugsweise in Mobilfunkgeräten, Einsatz, kann aber auch in anderen Systemen unter Erzielung der vorstehend aufgelisteten Vorteile benutzt werden.

Die Erfindung wird nachstehend anhand eines Ausführungsbeispiels unter Bezugnahme auf die Zeichnungen näher beschrieben. Es zeigen:
- Fig. 1: ein schematisches Blockschaltbild eines Ausführungsbeispiels in Form eines Phasenregelkreises,
- Fig. 2: ein Gesamtschaltbild einer Stromquellenanordnung in dem Phasenregelkreis,
- Fig. 3: einen Referenzstromgenerator mit vorgeschaltetem Pegelumsetzer,
- Fig. 4: eine Stromquellenschaltung mit vorgeschalteten Pegelumsetzern,
- Fig. 5: ein detailliertes Blockschaltbild eines Pegelumsetzers, und
- Fig. 6: ein detailliertes Blockschaltbild einer Stromquellenschaltung.

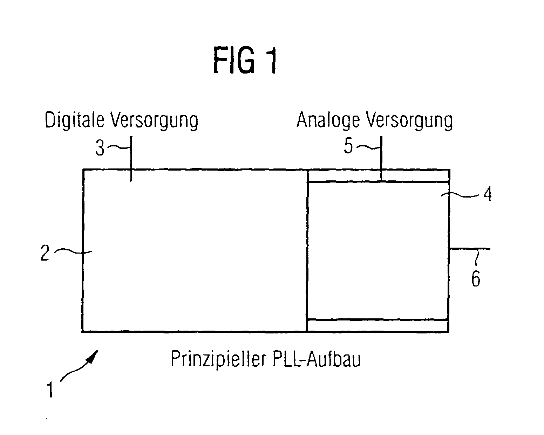

Der in Fig. 1 gezeigte Phasenregelkreis 1 enthält einen digitalen Schaltungsabschnitt 2 mit einer Spannungsversorgung 3, und einen analogen Schaltungsabschnitt 4 mit einer Spannungsversorgung 5, deren Versorgungspotential höher ist als dasjenige der Spannungsversorgung 3, zum Beispiel 5 V gegenüber 2,7 oder 3 V. Der analoge Schaltungsabschnitt 4 ist hier primär durch eine Stromquellenanordnung gebildet, an deren Ausgang 6 ein nicht dargestelltes Schleifenfilter mit nachgeschaltetem spannungsgesteuertem Oszillator angeschlossen ist, der ein hochfrequentes Signal für den Sende- oder Empfangsvorgang generiert und dessen Phasen- und/oder Frequenzlage durch einen in dem digitalen Schaltungsabschnitt 2 enthaltenen Phasenvergleicher oder Phasen/Frequenz-Detektor mit einem Referenzsignal verglichen wird. Das Ausgangssignal des Phasenvergleichers bzw. Phasen/Frequenz-Detektors wird an den analogen Schaltungsabschnitt 4 zur Steuerung des spannungsgesteuerten Oszillators mit großem Aussteuerungsbereich und damit Frequenzverstellbereich angelegt.

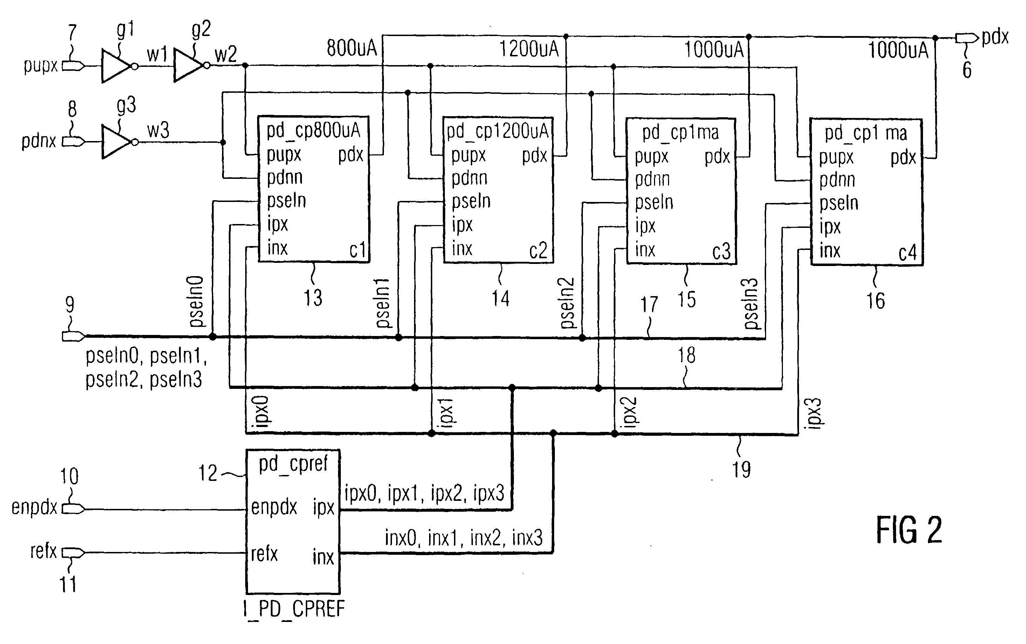

Die in Fig. 2 in größeren Einzelheiten gezeigte Stromquellenanordnung umfaßt fünf mit dem digitalen Schaltungsabschnitt 2 verbundene Eingänge 7 bis 11, einen Referenzstromgenerator 12 und vier Stromquellenschaltungen 13 bis 16, die für unterschiedliche Lade- und Entladeströme von hier 800 µA, 1000 µA (zweifach) und 1200 µA ausgelegt sind und deren Stromausgänge gemeinsam an den Ausgang 6 angeschlossen sind. Die Selektion der jeweils zu aktivierenden Stromquellenschaltung(en) 13 bis 16 erfolgt über vier selektiv mit den Stromquellenschaltungen verbundene Selektionsleitungen 17, die vieradrig mit dem Eingang 9 verbunden sind und über diesen vom digitalen Schaltungsabschnitt 2 je nach Bedarf ausgewählt werden. Weiterhin sind die Stromquellenschaltungen 13 bis 16 jeweils über zwei Referenzstromleitungen 18, 19 selektiv mit dem Referenzspannungsgenerator 12 verbunden, wobei die breiter dargestellten Leitungsabschnitte der Leitungen 17, 18, 19 jeweils vieradrig ausgelegte Leitungen symbolisieren.

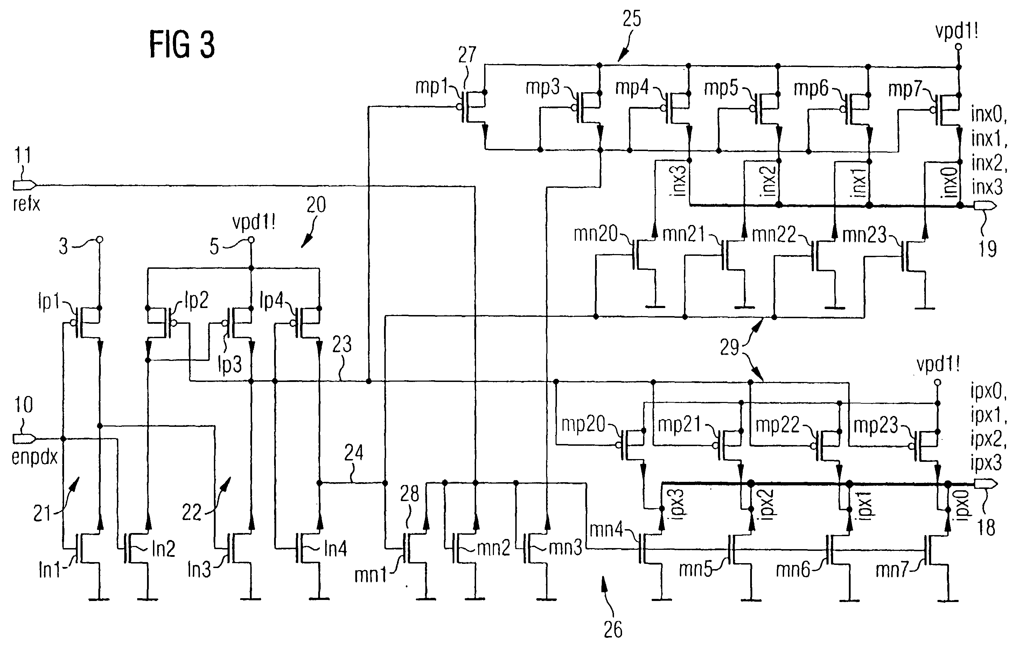

In Fig. 3 ist der Referenzstromgenerator 12 in größeren Einzelheiten dargestellt. Der Referenzstromgenerator enthält einen an den Eingang 10 angeschlossenen Pegelumsetzer 20, der das am Eingang 10 angelegte Aktivierungssignal, das zur Einund Ausschaltung des Referenzstromgenerators 12 dient und dessen Pegel zwischen Massepotential und dem Pegel der positiven Versorgungsspannung 3 des digitalen Schaltungsabschnitts 3 wechselt, in ein Schaltsignal umsetzt, dessen Pegel zwischen Massepotential und dem höheren Pegel der Spannungsversorgung 5 für den analogen Schaltungsabschnitt 4 wechselt. Der Pegelumsetzer 20 enthält eine an der Versorgungsspannung 3 liegende Eingangsstufe 21 und eine Umsetzund Ausgangsstufe 22, die mit der Spannungsversorgung 5 verbunden ist. Das Massepotential für die Eingangs- und Umsetz-/Ausgangs-Stufe ist jeweils identisch. Die Eingangsstufe 21 ist über jeweils auf inversem Potential (Massepotential oder hohes Versorgungspotential) liegenden Ausgängen mit zwei parallelen Zweigen der Umsetz- und Ausgangsstufe 22 verbunden und schaltet in diesen vorhandene Feldeffekttransistoren jeweils gegen Masse durch bzw. in den Sperrzustand. An den beiden komplementären Ausgängen 23, 24 des Pegelumsetzers 20 wird damit ein Schaltsignal erzeugt, das zwischen Massepotential und dem hohen Potentialwert der Versorgungsspannung 5 wechselt.

Der Referenzstromgenerator 12 enthält weiterhin eine Stromspiegelschaltung 25 zur Erzeugung von vier Referenzströmen inx0, 1, 2, 3, die über die Leitungen 19 zu den jeweils zugeordneten steuerbaren Stromquellenschaltungen 13 bis 16 gespeist werden, und eine Stromspiegelschaltung 26 zur Erzeugung von vier Referenzströmen ipx0, 1, 2, 3, die über die Leitungen 18 zu den Stromquellenschaltungen 13 bis 16 gespeist werden.

Über den Anschluß 11 wird von dem digitalen Schaltungsabschnitt 2 ein Referenzstrom von beispielsweise 100 µA in die Stromspiegelschaltung 26 eingeprägt. Aufgrund der gezeigten Verkopplung zwischen den Stromspiegelschaltungen 25 und 26 wird dieser Referenzstrom auch in die Stromspiegelschaltung 25 eingeprägt, so daß dort jeweils identische, positive und negative Ströme für die jeweiligen Stromquellenschaltungen 13 bis 16 generiert werden. Am Eingang der Stromspiegelschaltung 25 ist ein Schalter 27 in Form eines Feldeffekttransistors angeordnet, der durch den Ausgang 23 des Pegelumsetzers 20 gesteuert wird. Ebenso ist am Eingang der Stromspiegelschaltung 26 ein Schalter 28 in Form eines Feldeffekttransistors angebracht, der durch den Ausgang 24 des Pegelumsetzers 20 gesteuert wird. Wenn das am Eingang 10 anliegende Aktivierungssignal die Deaktivierung signalisiert und niedrigen Pegel aufweist, werden beide Schalter 27 und 28 durchgeschaltet, so daß die Stromspiegelschaltungen 25, 26 inaktiv werden und keine Referenzströme mehr zu den Stromquellenschaltungen 13 bis 16 speisen. Dieser Abschaltvorgang wird durch die summarisch mit 29 bezeichneten Abschalttransistoren gefördert, durch die die einzelnen Stromleitungen 18, 19 auf das jeweils entgegengesetzte Spannungspotential umgeschaltet werden. Da der Referenzstrom am Eingang 11 potentialunabhängig eingeprägt wird, ist hier kein Pegelumsetzer erforderlich, was den Schaltungsaufwand verringert.

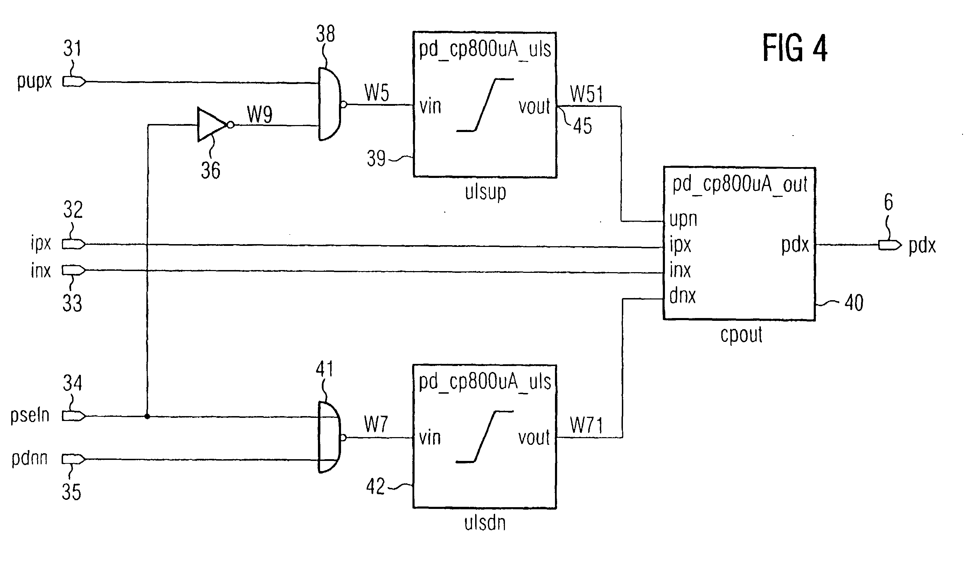

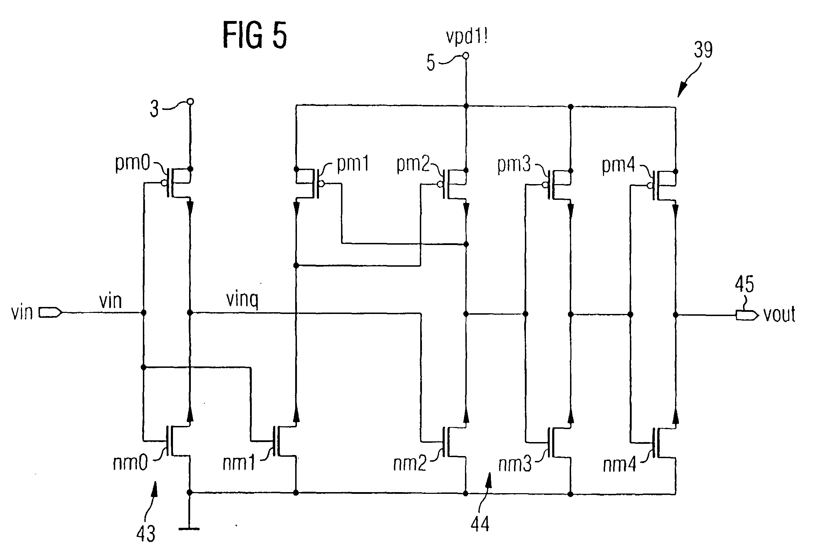

In Fig. 4 ist die in Fig. 2 gezeigte Stromquellenschaltung 13 in größeren Einzelheiten dargestellt. Dieser Aufbau ist auch bei den Stromquellenschaltungen 14, 15 und 16 vorhanden. Die Stromquellenschaltung 13 enthält fünf Eingänge 31 bis 35, die in der in Fig. 2 gezeigten Weise mit den Anschlüssen 7 bis 9 bzw. mit den Leitungen 18, 19 (Anschlüsse 32, 33) verbunden sind. Am Eingang 31 liegt eine Steuerspannung zur Ein- und Ausschaltung der für die Hochpegelseite vorgesehenen Ausgangsstufe der Stromquellenschaltung 40 an. Ebenso ist an dem Eingang 35 eine zwischen Masse und niedriger Versorgungsspannung 3 wechselnde Steuerspannung zur Ein- und Ausschaltung der Niederpegel-Ausgangsstufe der Stromquellenschaltung 40 angelegt. Der Eingang 31 ist mit einem logischen Glied 38 in Form eines NAND-Glieds verschaltet, an dessen anderem Eingang das über einen Invertierer 36 invertierte Selektionssignal am Anschluß 34 angelegt ist. Das Ausgangssignal des logischen Glieds 38 ist an einen Pegelumsetzer 39 angeschlossen, dessen Schaltungsaufbau in Fig. 5 dargestellt ist und der den niedrigen Spannungshub des Ausgangssignals des logischen Glieds 38 (mit der Spannungsversorgung 3 betrieben) in den höheren Spannungshub der Versorgungsspannung 5 umsetzt. Das Ausgangssignal des Pegelumsetzers 39 ist an einen Eingang upn der Stromquellenschaltung 40 angelegt.

Das am Eingang 35 angelegte Steuersignal wird an ein logisches Glied 41 in Form eines NOR-Glieds 41 angelegt, an dessen anderem Eingang das am Eingang 34 zugeführte Selektionssignal anliegt. Dem logischen Glied 41 ist ein Pegelumsetzer 42 nachgeschaltet, der gleichen Aufbau wie der Pegelumsetzer 39 aufweist und die Eingangsspannung auf einen höheren Spannungspegel transformiert. Das Ausgangssignal des Pegelumsetzers 42 ist an den Eingang dnx der Stromquellenschaltung 40 angelegt. Die über die Anschlüsse 32, 33 zugeführten bzw. abgeführten Referenzströme werden in die Eingänge ipx, inx der Stromquellenschaltung 40 eingeprägt.

Durch das Selektionssignal am Eingang 34 können die logischen Glieder 38, 41 gleichzeitig aktiviert oder deaktiviert werden, so daß sie als Ein- und Ausschalter dienen. Bei fehlender Selektion werden die an den Eingängen 31, 35 anliegenden Steuersignale nicht an die Pegelumsetzer 39, 42 angelegt, so daß diese und die Stromquellenschaltung 40 abgeschaltet sind, wobei allerdings die Referenzströme weiterhin in die Stromquellenschaltung 40 eingespeist werden. Damit kann diese sofort bei Selektion der Stromquellenschaltung 13 ohne Einschwingvorgänge aktiviert werden. Gleiches gilt selbstverständlich auch für die weiteren Stromquellenschaltungen 14, 15, 16.

Der in Fig. 5 gezeigte Pegelumsetzer 39 (bzw. 42) umfaßt ähnlich wie der in Fig. 2 gezeigten Pegelumsetzer 20 eine Eingangsstufe 43, an die das zwischen den niedrigeren Potentialwerten der digitalen Versorgungsspannung 3 umschaltende Eingangssignal vin angelegt ist. Die Eingangsstufe 43 liegt zwischen niedriger Versorgungsspannung 3 und Masse. An die Eingangsstufe 43 ist wie beim Pegelumsetzer 20 eine Umsetz- und Ausgangsstufe 44 angeschlossen, die zwischen hohe Versorgungsspannung 5 und Masse geschaltet ist und die am Ausgangsanschluß 45 abgegebene Ausgangsspannung zwischen Massepotential und hohem Versorgungsspannungspegel am Anschluß 5 umschaltet, das heißt den Spannungshub entsprechend erhöht.

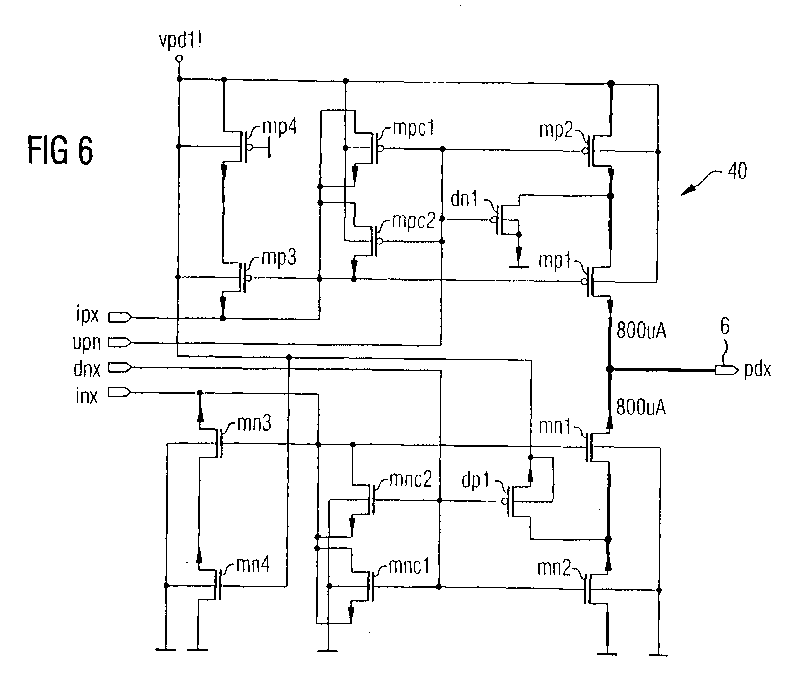

In Fig. 6 ist der Aufbau der Stromquellenschaltung 40 in größeren Einzelheiten dargestellt. Dieser Aufbau ist an sich aus der EP 0 905 598 A1, insbesondere Fig. 2 und zugehörige Beschreibung an sich bekannt. Der Offenbarungsgehalt dieser Druckschrift wird in vorliegende Anmeldung in vollem Umfang zur Vermeidung von Wiederholungen einbezogen. Diese versorgungsspannungsunabhängige, für einen weiten Versorgungsspannungsbereich dynamisch kompensierte Stromquellenschaltung eignet sich insbesondere für den Einsatz in vorliegender Erfindung, bei der mit unterschiedlichen Versorgungsspannungen gearbeitet wird.

## Patentansprüche

1. Elektronische Schaltung, insbesondere Phasenregelkreis für ein Mobilfunkgerät, mit einem digitalen Schaltungsabschnitt (2) und einem mit diesem verbundenen analogen Schaltungsabschnitt (4), insbesondere Hochfrequenzabschnitt, der von dem digitalen Schaltungsabschnitt (2) Steuersignale empfängt, wobei für den digitalen und den analogen Schaltungsabschnitt (2, 4) jeweils getrennte Spannungsversorgungen (3, 5) vorgesehen sind,
**dadurch gekennzeichnet, daß**
die Spannungsversorgung (3) für den digitalen Schaltungsabschnitt (2) auf niedrigerem Potentialpegel als die Spannungsversorgung (5) für den analogen Schaltungsabschnitt (4) eingestellt ist, daß der analoge Schaltungsabschnitt (4) mindestens zwei gesteuerte Stromquellenschaltungen (13, 14, 15, 16) enthält, deren Stromausgänge (6) miteinander verbunden sind, und einen vorgeschalteten Referenzstromgenerator (12) enthält, der durch ein von dem digitalen Schaltungsabschnitt (2) zugeführtes Aktiverungssignal (enpdx) steuerbar ist, wobei das Aktivierungssignal (enpdx) über einen am Eingang des Referenzstromgenerators (12) angeordneten Pegelumsetzer (20) umgesetzt wird, um mittels mindestens zwei Referenzstromzweigen Referenzströme (inx, ipx) zu erzeugen, die in die Stromquellenschaltungen (13, 14, 15, 16) eingespeist werden, daß eine in dem digitalen Schaltungsabschnitt (2) angeordnete Selektionseinrichtung zur Erzeugung von Selektionssignalen (pseln) für die Auswahl mindestens einer zu aktivierenden Stromquellenschaltung (13, 14, 15, 16) vorgesehen ist, daß die Selektionssignale (pseln) an Eingänge der Stromquellenschaltungen (13, 14, 15, 16) und an dort vorhandene logische Glieder (38, 41) angelegt werden, denen Pegelumsetzer (39, 42) nachgeschaltet sind, um Schaltsignale (upn, dnx) zu erzeugen, die die Stromausgänge (6) der jeweiligen Stromquellenschaltungen (13, 14, 15, 16) ansteuern.

2. Schaltung nach Anspruch 1, **dadurch gekennzeichnet, daß** zwischen den digitalen Schaltungsabschnitt (2) und den analogen Schaltungsabschnitt (4) mindestens ein Pegelumsetzer (20, 39, 42) geschaltet ist, der ein oder mehrere vom digitalen Schaltungsabschnitt (2) erzeugte Schaltsignale auf höheren Pegel transformiert.

3. Schaltung nach Anspruch 1 oder 2, **gekennzeichnet durch** eine mit dem Ausgang (6) der Stromquellenschaltung (13 bis 16) verbundene Steuerspannungserzeugungseinrichtung, vorzugsweise in Form eines Schleifenfilters, die zur Erzeugung der Steuerspannung für einen phasen- und/oder frequenzstarr geregelten spannungsgesteuerten Oszillator dient, dessen Ausgangssignal zu einem im digitalen Schaltungsabschnitt (2) enthaltenen Phasen- oder Phasen/Frequenz-Detektor gespeist wird.

4. Schaltung nach einem der Ansprüche 1 bis 3, **dadurch gekennzeichnet, daß** der Referenzstromgenerator einen oder zwei elektronische Schalter (27, 28) zur gleichzeitigen Ausschaltung aller Referenzstromzweige enthält, wobei der oder die Schalter (27, 28) an den Ausgang (23, 24) eines Pegelumsetzers (20) angeschlossen sind.

5. Schaltung nach einem der Ansprüche 1 bis 4, **dadurch gekennzeichnet, daß** der oder die Pegelumsetzer (20, 39, 42) jeweils eine mit der Versorgungsspannung des digitalen Schaltungsabschnitts (2) gespeisten Eingangsstufe (21, 43), an der ein vom digitalen Schaltungsabschnitt (2) erzeugtes Schaltsignal anliegt, und eine mit der Eingangsstufe verbundenen, mit der höheren Versorgungsspannung (5) des analogen Schaltungsabschnitts (4) gespeiste Umsetz- und Ausgangsstufe (22, 44) enthalten, deren Ausgangsspannung in Abhängigkeit vom eingangsseitig angelegten Schaltsignal zwischen Masse und der höheren Versorgungsspannung (5) umgeschaltet wird, wobei die Masse für beide Zweige gemeinsam vorgesehen ist.

## Claims

1. Electronic circuit, particularly a phase-locked loop for a mobile transceiver, comprising a digital circuit section (2) and an analogue circuit section (4) connected to said digital circuit section (2), particularly a radiofrequency section which receives control signals from the digital circuit section (2), separate voltage supplies (3, 5) being provided in each case for the digital circuit section and the analogue circuit section (2, 4),
**characterized in that** the voltage supply (3) for the digital circuit section (2) is set to a lower potential level than the voltage supply (5) for the analogue circuit section (4), **in that** the analogue circuit section (4) contains at least two controlled current source circuits (13, 14, 15, 16), the current outputs (6) of which are connected to one another, and contains a preceding reference current generator (12) which can be controlled by an activation signal (enpdx) supplied from the digital circuit section (2), the activation signal (enpdx) being converted via a level converter (20) arranged at the input of the reference current generator (12) in order to generate, by means of at least two reference current branches, reference currents (inx, ipx) which are fed into the current source circuits (13, 14, 15, 16), **in that** a selection device, arranged in the digital circuit section (2), for generating selection signals (pseln) for selecting at least one current source circuit (13, 14, 15, 16) to be activated is provided, **in that** the selection signals (pseln) are applied to inputs of the current source circuits (13, 14, 15, 16) and to logic elements (38, 41) which are present there and which are followed by level converters (39, 42) in order to generate switching signals (upn, dnx) which control the current outputs (6) of the respective current source circuits (13, 14, 15, 16).

2. Circuit according to Claim 1, **characterized in that** between the digital circuit section (2) and the analogue circuit section (4), at least one level converter (20, 39, 42), is connected which transforms to a higher level one or more switching signals generated by the digital circuit section (2).

3. Circuit according to Claim 1 or 2, **characterized by** a control voltage generating device connected to the output (6) of the current source circuit (13 to 16), preferably in the form of a loop filter which is used for generating the control voltage for a voltage-controlled oscillator which is controlled to be phase-locked and/or frequency-locked and the output signal of which is fed to a phase or phase/frequency detector contained in the digital circuit section (2).

4. Circuit according to one of Claims 1 to 3, **characterized in that** the reference current generator contains one or two electronic switches (27, 28) for switching all reference current branches off at the same time, the switch or switches (27, 28) being connected to the output (23, 24) of a level converter (20).

5. Circuit according to one of Claims 1 to 4, **characterized in that** the level converter or converters (20, 39, 42) in each case contain an input stage (21, 43) which is fed with the supply voltage of the digital circuit section (2) and at which a switching signal generated by the digital circuit section (2) is present, and a conversion and output stage (22, 44) which is connected to the input stage and which is fed with the higher supply voltage (5) of the analogue circuit section (4) and the output voltage of which is switched between earth and the higher supply voltage (5) in dependence on the switching signal applied to the input end, the earth being provided jointly for both branches.

## Revendications

1. Circuit électronique, notamment boucle à verrouillage de phase pour un appareil de téléphonie mobile, comprenant une partie (2) de circuit numérique et une partie (4) de circuit analogique qui y est reliée, notamment une partie en haute fréquence qui reçoit des signaux de commande de la partie (2) de circuit numérique, des alimentations (3, 5) en tension séparées étant prévues pour la partie (2) de circuit numérique et pour la partie (4) de circuit analogique,
**caractérisé en ce que**
la tension (3) d'alimentation de la partie (2) de circuit numérique est réglée à un niveau de potentiel plus bas que la tension (5) d'alimentation de la partie (4) de circuit analogique **en ce que** la partie (4) de circuit analogique comporte au moins deux circuits (13, 14, 15, 16) de courant commandés, dont les sorties (6) de courant sont reliées entre elles, et comporte un générateur (12) de courant de référence monté en amont, qui peut être commandé par un signal (enpdx) d'activation envoyé par la partie (2) de circuit numérique, le signal (enpdx) d'activation étant transformé par un convertisseur (20) de niveau monté à l'entrée du générateur (12) de courant de référence pour produire au moyen d'au moins deux branches de courant de référence des courants (inx, ipx) de référence qui sont injectés dans les circuits (13, 14, 15, 16) source de courant, **en ce qu'**il est prévu un dispositif de sélection monté dans la partie (2) de circuit numérique et de production de signaux (pseln) de sélection pour choisir au moins u un circuit (13, 14, 15, 16) de source de courant à activer, **en ce que** les signaux (pseln) de sélection sont envoyés aux entrées des circuits (13, 14, 15, 16) de source de courant et à des éléments (38, 41) logiques qui s'y trouvent, le convertisseur (39, 42) de niveau étant monté en aval de ceux-ci pour produire des signaux (upn, dnx) de commutation qui commandent les sorties (6) de courant des circuits (13, 14, 15, 16) respectifs de source de courant.

2. Dispositif suivant la revendication 1,
**caractérisé**
**en ce qu'**il est monté entre la partie (2) de circuit numérique et la partie (4) de circuit analogique, au moins un convertisseur (20, 39, 42) de niveau, qui met à un niveau plus élevé un ou plusieurs signaux de commutation produit par la partie (2) de circuit numérique.

3. Dispositif suivant la revendication 1 ou 2 ,
**caractérisé**
**par** un dispositif de production d'une tension de commande relié à la sortie (6) du circuit (13 à 16) de source de courant, de préférence sous la forme d'un filtre à boucle qui sert à la production de la tension de commande pour un oscillateur réglé sur une phase et/ou une fréquence fixe et commandé en tension et dont le signal de sortie est envoyé à un détecteur de phase ou un détecteur de phase/fréquence contenu dans la partie (2) de circuit numérique.

4. Dispositif suivant l'une des revendications 1 à 3,
**caractérisé**
**en ce que** le générateur de courant de référence comporte un ou deux commutateurs (27, 28) électroniques pour mettre simultanément hors circuit toutes les branches de courant de référence, le ou les commutateurs (27, 28) étant raccordés à la sortie (23, 24) d' un convertisseur (20) de niveau.

5. Dispositif suivant l'une des revendications 1 à 4,
**caractérisé**
**en ce que** le ou les convertisseurs (20, 39, 42) de niveau comportent respectivement un étage (21, 43) d'entrée, qui est alimenté en la tension d'alimentation de la partie (2) de circuit numérique et auquel s'applique le signal de commutation produit par la partie (2) de commutation numérique, et comporte un étage (22, 44) de conversion et de sortie reliés à l'étage d'entrée et alimenté par la tension (5) d'alimentation plus haute de la partie (4) de circuit analogique dont la tension de sortie est inversée en fonction du signal de commutation appliqué du côté entrée entre la masse et la tension (5) d'alimentation plus haute, la masse étant prévue de façon commune pour les deux branches.
